# EUROPEAN PATENT APPLICATION

(11) **EP 3 940 801 A1**
(43) Date of publication of application: **19.01.2022**
(21) Application number: 20770218.4
(22) Date of filing: 02.03.2020
(51) Int. Cl.: H01L 37/00, H01L 23/12, H01L 25/10, H01L 25/11, H01L 25/18, H05K 1/18

(54) **SEMICONDUCTOR INTEGRATED CIRCUIT DEVICE HAVING POWER GENERATION FUNCTION**

(30) Priority: 12.03.2019 JP 2019044970
(71) Applicant: GCE Institute Inc., Tokyo 104-0061 (JP)
(72) Inventor: GOTO, Hiroshi, Tokyo 104-0061 (JP); SAKATA Minoru, Tokyo 104-0061 (JP)
(74) Representative: Rings, Rolf
(86) International application number: PCT/JP2020/008578
(87) International publication number: WO 2020/184234

(57) **Abstract**

PROBLEM TO BE SOLVED: To provide a semiconductor integrated circuit device with an electric power generation function, which can prevent the circuit board from increasing in size.

MEANS TO SOLVE THE PROBLEM: A semiconductor integrated circuit device 200 with an electric power generation function has a semiconductor integrated circuit device and a thermoelectric element 1. The semiconductor integrated circuit device includes a package 210 to house a semiconductor integrated circuit chip 230. The semiconductor integrated circuit chip 230 has a lower surface opposing the circuit board and an upper surface opposing the mounting surface. The thermoelectric element 1 includes a casing unit having a housing unit, a first electrode unit provided inside the housing unit, a second electrode unit provided inside the housing unit, separated from and opposing the first electrode unit in the first direction, and having a work function different from that of the first electrode unit, and a middle unit provided between the first electrode unit and the second electrode unit, and including a nanoparticle having a work function between the work function of the first electrode unit and the work function of the second electrode unit, in the housing unit. The casing unit is provided on the upper surface side of the semiconductor integrated circuit chip 230.

## Description

### TECHNICAL FIELD

The present invention relates to a semiconductor integrated circuit device with an electric power generation function.

### BACKGROUND ART

Recently, effective use of heat that is produced by artificial heat sources is under study. Semiconductor integrated circuit devices are one of such artificial heat sources. Semiconductor integrated circuit devices produce high heat during operation. At present, this heat is dissipated to the outside of the semiconductor integrated circuit devices via a heat sink or the like.

Patent literature 1 discloses a thermoelectric element, which has electrically-insulating spherical nanobeads, separating between an emitter-electrode layer and a collector-electrode layer at a submicron interval, in which the work function of the emitter-electrode layer is smaller than the work function of the collector-electrode layer, and in which the space between the electrodes separated by the spherical nanobeads is filled with a metal nanobead dispersion liquid, in which nano-particles having a work function between those of the emitter-electrode layer and the collector-electrode layer, and having a smaller particle diameter than the spherical nanobeads, is dispersed.

### CITATION LIST

### PATENT LITERATURE

Patent Literature 1: Japanese Patent No. 6147901

### SUMMARY OF INVENTION

### PROBLEM TO BE SOLVED BY THE INVENTION

The thermoelectric element disclosed in patent literature 1 makes the work function of the emitter electrode layer smaller than the work function of the collector electrode layer, and fills the space between the electrodes separated by spherical nanobeads with a metal nanoparticle dispersion liquid. As a result of this, the thermoelectric element can generate electricity even if there is no mechanism for creating temperature differences between the electrodes of the thermoelectric element like the Seebeck element.

If a thermoelectric element like this that does not require temperature differences between electrodes can harvest the thermal energy produced by the semiconductor integrated circuit device and produce electric power, it is promising as an auxiliary power source for electronic devices in which the semiconductor integrated circuit device is used.

However, it is necessary to mount the thermoelectric element on the circuit board or elsewhere, which is likely to result in an increase in the size of the circuit board.

The present invention has been made in view of the above circumstances, and it is therefore an object of the present invention to provide a semiconductor integrated circuit device with an electric power generation function that can prevent an increase in the size of the circuit board.

### MEANS FOR SOLVING THE PROBLEMS

The semiconductor integrated circuit device with an electric power generation function according to the first invention is a semiconductor integrated circuit device with an electric power generation function, having a semiconductor integrated circuit device and a thermoelectric element to convert thermal energy released from the semiconductor integrated circuit device into electrical energy, in which the semiconductor integrated circuit device includes a package to house a semiconductor integrated circuit chip, in which the semiconductor integrated circuit chip has a lower surface opposing a circuit board and an upper surface opposing the lower surface, in which the thermoelectric element includes a casing unit having a housing unit, a first electrode unit provided inside the housing unit; and a second electrode unit provided inside the housing unit, separated from and opposing the first electrode unit in a first direction, and having a work function different from that of the first electrode unit, and a middle unit provided between the first electrode unit and the second electrode unit, and including a nanoparticle having a work function between the work function of the first electrode unit and the work function of the second electrode unit, in the housing unit, and in which the casing unit is provided on an upper surface side of the semiconductor integrated circuit chip.

Based on the first invention, in the semiconductor integrated circuit device with an electric power generation function according to a second invention, the thermoelectric element further includes a first bonding wire, electrically connected with the first electrode unit, and leading the first electrode unit to outside of the housing unit, and a second bonding wire, electrically connected with the second electrode unit, and leading the second electrode unit to outside of the housing unit, and a first electrical contact between the first electrode unit and the first bonding wire and a second electrical contact between the second electrode unit and the second bonding wire are both provided inside the housing unit.

Based on the second invention, in the semiconductor integrated circuit device with an electric power generation function according to a third invention, the casing unit includes a first board having a first main surface and a second main surface opposing the first main surface and facing the upper surface of the semiconductor integrated circuit chip, the thermoelectric element further includes a first outer terminal, electrically connected with the first bonding wire, and a second outer terminal, electrically connected with the second bonding wire, and the first outer terminal and the second outer terminal are both provided on the first main surface of the first board.

Based on any one of the first invention to the third invention, in the semiconductor integrated circuit device with an electric power generation function according to a fourth invention, the thermoelectric element includes at least one of a parallel flat plate-type thermoelectric element and a comb tooth-type thermoelectric element.

Based on any one of the first invention to the fourth invention, the semiconductor integrated circuit device with an electric power generation function according to a fifth invention further has a power supply circuit, capable of receiving as input each of external input power supplied from outside and auxiliary input power supplied from the thermoelectric element, converting each of the external input power and the auxiliary input power into semiconductor integrated circuit device input power, and outputting the semiconductor integrated circuit device input power to the semiconductor integrated circuit device.

### ADVANTAGEOUS EFFECTS OF INVENTION

With the semiconductor integrated circuit device with an electric power generation function according to the first invention, a first electrode unit, a second electrode unit having a work function different from that of the first electrode unit, and a middle unit including nanoparticles having a work function between the work function of the first electrode unit and the work function of the second electrode unit are included inside a housing unit of a casing unit of a thermoelectric element. By this means, the thermoelectric element can generate electric power without creating temperature differences in the thermoelectric element. Consequently, there is no need for low-temperature materials or a chiller for cooling low-temperature materials. Furthermore, the casing unit of the thermoelectric element is provided on the upper surface of a semiconductor integrated circuit chip. By this means, it is not necessary to add a new area on the circuit board for providing the thermoelectric element, so that it is possible to prevent the circuit board from increasing in size.

With the semiconductor integrated circuit device with an electric power generation function according to the second invention, the first and second electrical contacts are both provided inside the housing unit. By this means, when incorporating the semiconductor integrated circuit device with an electric power generation function in secondary products, it is possible to prevent the first and second electrical contacts from breaking or getting damaged, for example, while handling the semiconductor integrated circuit device with an electric power generation function, or while working on the installation of the semiconductor integrated circuit device with an electric power generation function. By this means, it is possible to prevent the loss of the semiconductor integrated circuit device with an electric power generation function, which might occur during the manufacturing of secondary products.

With the semiconductor integrated circuit device with an electric power generation function according to the third invention, the casing unit includes a first board, which has a first main surface and a second main surface opposing the first main surface and facing an upper surface of a semiconductor integrated circuit chip. Furthermore, the first and second outer terminals are both provided on the first main surface of the first board. The first main surface can, for example, provide a large area for each of the first and second outer terminals, compared to the side surfaces of the casing unit. Furthermore, compared to the side surfaces of the casing unit, the first main surface is easy for the operator to see/identify, and makes it easy for the work robot to extract the work point. These, for example, make it possible to facilitate the work for establishing electrical connections between the thermoelectric element and secondary products, and, for example, improve the throughput of secondary products. In addition, the reliability of the assembling secondary products having the semiconductor integrated circuit device with an electric power generation function improves.

With the semiconductor integrated circuit device with an electric power generation function according to the fourth invention, the thermoelectric element includes one of a parallel flat plate-type thermoelectric element and a comb-tooth-type thermoelectric element. By this means, one example of the thermoelectric element's structure is realized.

With the semiconductor integrated circuit device with an electric power generation function according to the fifth invention, a power supply circuit is further provided. The power supply circuit converts each of external input power supplied from the outside and auxiliary input power supplied from the thermoelectric element into semiconductor integrated circuit device input power, and outputs each semiconductor integrated circuit device input power to the semiconductor integrated circuit device. By this means, the power consumption of the semiconductor integrated circuit device with an electric power generation function can be reduced.

### BRIEF DESCRIPTION OF DRAWINGS

FIG. 1A is a schematic cross-sectional view to show an example of a semiconductor integrated circuit device with an electric power generation function according to the first embodiment, and
FIG. 1B is a schematic exploded cross-sectional view to show an example of the semiconductor integrated circuit device with an electric power generation function according to the first embodiment in an exploded state;
FIG. 2 is a schematic cross-sectional view to show an example of an electronic device using the semiconductor integrated circuit device with an electric power generation function according to the first embodiment;
FIG. 3A is a schematic cross-sectional view to show an example of a thermoelectric element, and FIG. 3B is a schematic plan view taken along the line IIIB-IIIB in FIG. 3A;
FIG. 4 is a schematic cross-sectional view to show an example of joining of the thermoelectric element;
FIG. 5A is a schematic cross-sectional view to show an example of a middle unit, and FIG. 5B is a schematic cross-sectional view to show another example of the middle unit;
FIGs. 6A and 6B are schematic cross-sectional views to show an example of a thermoelectric element according to the first modification, and FIG. 6C is a schematic cross-sectional view taken along the line VIC-VIC in FIG. 6A;
FIG. 7 is a schematic cross-sectional view to show an example of joining of the thermoelectric element according to the first modification;
FIG. 8 is a schematic cross-sectional view to show an example of a slit;
FIGs. 9A and 9B are schematic cross-sectional views to show an example of solvent injection;
FIG. 10 is a schematic block diagram to show an example of a semiconductor integrated circuit device with an electric power generation function according to a second embodiment;
FIG. 11 is a schematic circuit diagram to show an example of the semiconductor integrated circuit device with an electric power generation function according to a second embodiment; and
FIG. 12 is a schematic circuit diagram to show an example of the semiconductor integrated circuit device with an electric power generation function according to a first modification of the second embodiment.

### DESCRIPTION OF EMBODIMENTS

Hereinafter, a number of embodiments of the present invention will be described with reference to the drawings. Note that, in each drawing, the direction of height is the first direction Z, one plane direction that intersects (for example, that is orthogonal to) the first direction Z is a second direction X, and the other plane direction that intersects (for example, that is orthogonal) both the first direction Z and the second direction X is a third direction Y. Furthermore, in each drawing, common parts will be assigned common reference numerals, and duplicate description will be omitted.

### (First embodiment)

### < Semiconductor integrated circuit device with electric power generation function >

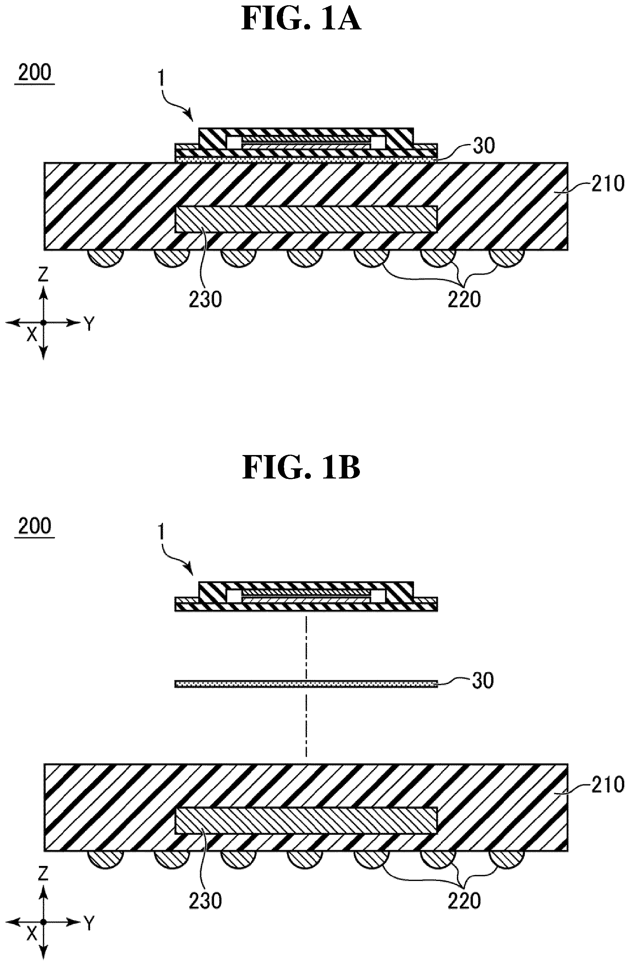

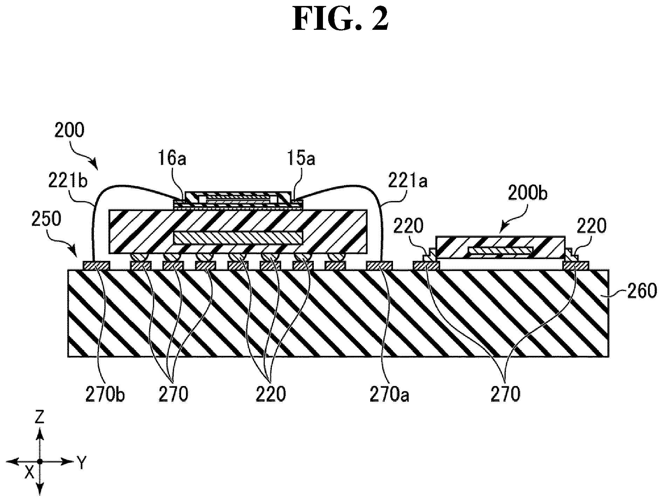

FIG. 1A is a schematic cross-sectional view to show an example of a semiconductor integrated circuit device with an electric power generation function according to the first embodiment. FIG. 1B is a schematic exploded cross-sectional view to show an example of the semiconductor integrated circuit device with an electric power generation function according to the first embodiment in an exploded state. FIG. 2 is a schematic cross-sectional view to show an example of an electronic device using the semiconductor integrated circuit device with an electric power generation function according to the first embodiment.

As shown in FIGs. 1 and FIG. 2, a semiconductor integrated circuit device 200 with a power generation function according to the first embodiment has a package 210 and a thermoelectric element 1 (hereinafter abbreviated as "semiconductor integrated circuit device"). The package 210 is made of, for example, an insulating resin, and
a semiconductor integrated circuit chip 230 is housed inside. Note that the package 210 is not limited to one made of an insulating resin. Furthermore, the semiconductor integrated circuit chip 230 has a lower surface opposing a circuit board 260 and an upper surface opposing the lower surface. A plurality of external terminals 220 are provided on the lower surface side of the semiconductor integrated circuit chip 230. The external terminals 220 electrically connect between the semiconductor integrated circuit chip 230 and the electrical wires 270 provided on the circuit board 260.

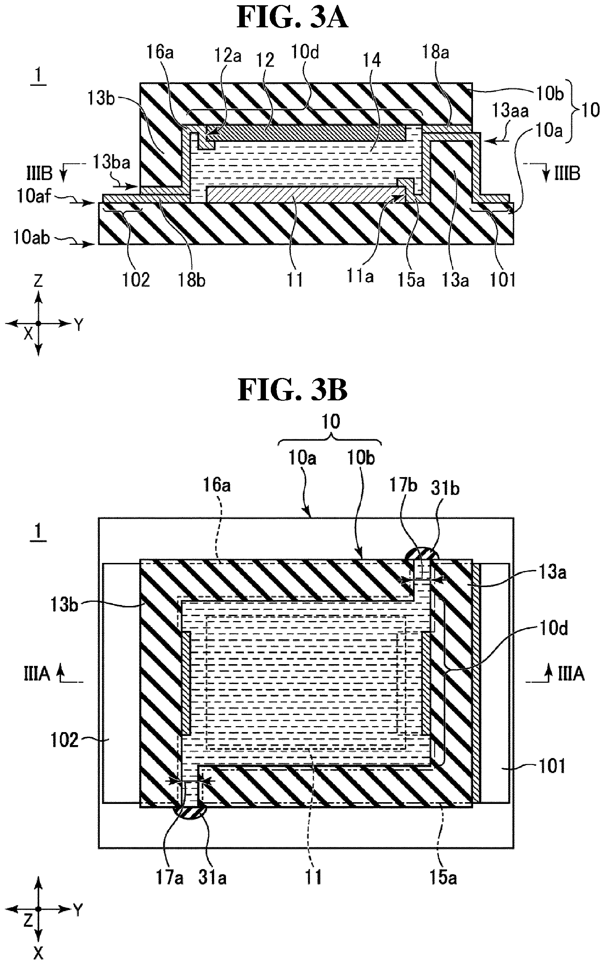

The thermoelectric element 1 converts the thermal energy produced from the semiconductor integrated circuit device 200 -- especially the semiconductor integrated circuit chip 230 -- into electrical energy. Although the details of the thermoelectric element 1 will be described later, the thermoelectric element 1 includes, for example, as shown in FIG. 3, a casing unit 10 having a housing unit 10d, a first electrode unit 11 provided inside the housing unit 10d, a second electrode unit 12 provided inside the housing unit 10d, opposing the first electrode unit 11 at a distance in the first direction Z, and having a work function different from that of the first electrode unit 11, and a middle unit 14, provided between the first electrode unit 11 and the second electrode unit 12, inside the housing unit 10d, and including nanoparticles having a work function between the work function of the first electrode unit 11 and the work function of the second electrode unit 12. The casing unit 10 is provided on the package 210 on the upper surface side of the semiconductor integrated circuit chip 230. Note that at least a part of the casing unit 10 may be housed in the package 210, for example.

The thermoelectric element 1 further includes a first bonding wire 15a that is electrically connected with the first electrode unit 11 and leads the first electrode unit 11 to the outside of the housing unit 10d, and a second bonding wire 16a that is electrically connected with the second electrode unit 12 and leads the second electrode unit 12 to the outside of the housing unit 10d. The first bonding wire 15a is electrically connected with the electrical wire 270a, provided on the circuit board 260, via the first bonding wire 221a. The second bonding wire 16a is electrically connected with the electrical wire 270b, provided on the circuit board 260, via the second bonding wire 221b.

Such a semiconductor integrated circuit device 200 is mounted on the circuit board 260, together with another semiconductor integrated circuit device 200b, to form an electronic device such as, for example, a circuit board for an electronic device such as a personal computer.

### « Thermoelectric element: 1 »

The thermoelectric element 1 is electrically insulated from the package 210, and thermally connected with the package 210. One or more thermoelectric elements 1 are provided on the package 210.

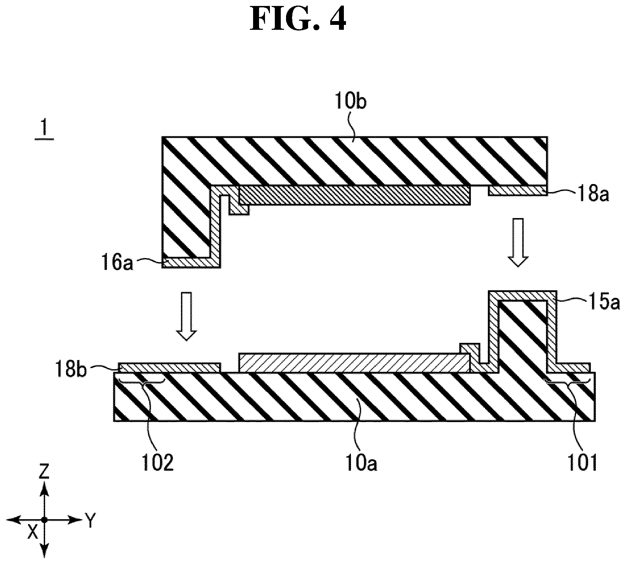

FIGs. 3A and 3B are schematic cross-sectional views to show examples of the thermoelectric element 1. The schematic cross section shown in FIG. 3A is taken along the line IIIA-IIIA in FIG. 3B. The schematic cross section shown in FIG. 3B is taken along the line IIIB-IIIB in FIG. 3A. FIG. 4 is a schematic cross-sectional view to show an example of joining of the thermoelectric element 1. FIG. 4 corresponds to the schematic cross section shown in FIG. 3A.

As shown in FIGs. 3A and 3B, the thermoelectric element 1 includes a casing unit 10, a first electrode unit 11, a second electrode unit 12, and a middle unit 14. The thermoelectric element 1 is bonded to the surface of the package 210, on the upper surface side of the semiconductor integrated circuit chip 230, by, for example, an adhesive member 30 (see FIG. 1A and 1B). Alternatively, the casing unit 10 is fixed, on the surface of the package 210 on the upper surface side of the semiconductor integrated circuit chip 230, by a brazing material such as solder. The thickness of the thermoelectric element 1 along the first direction Z is approximately 20 µm to 6 mm.

The casing unit 10 includes a first board 10a and a second board 10b, in the thermoelectric element 1. The thickness of each of the first and second boards 10a and 10b along the first direction Z is, for example, 10 µm or more, up to 2 mm. For the material of both the first and second boards 10a and 10b, a flat insulating material may be chosen. Examples of insulating materials may include silicon, quartz, glass such as Pyrex (registered trademark), and insulating resins. The first and second boards 10a and 10b may be shaped like thin plates, or may be, for example, shaped like flexible films. For example, when the first and second boards 10a or 10b are shaped like flexible films, for example, PET (PolyEthylene Terephthalate), PC (PolyCarbonate), polyimide, or the like can be used. Furthermore, the first and second boards 10a and 10b do not have to be insulating. The surface of semiconductor boards or metal boards may be coated with, for example, an insulating film. To illustrate an example of such a board coated with an insulating film, for example, a silicon (Si) board having a silicon oxide (for example, SiO₂) film formed on its surface may be used.

The first board 10a includes, for example, a first support unit 13a. The first support unit 13a extends from the first board 10a toward the second board 10b, along the first direction Z. The planar shape of the first support unit 13a is shaped like the letter "L", extending in both the second direction X and the third direction Y, when viewed from the first direction Z. The second board 10b includes, for example, a second support unit 13b. The second support unit 13b extends from the second board 10b toward the first board 10a, along the first direction Z. The planar shape of the second support unit 13b is shaped like the letter "L", extending in both the second direction X and the third direction Y, when viewed from the first direction Z. The thickness of both the first and second support units 13a and 13b along the first direction Z is, for example, 10 nm or more, up to 10 µm. The second support unit 13b and the first support unit 13a are separated from each other via, for example, two slits 17a and 17b.

The first and second support units 13a and 13b may be both provided integrally with the first and second boards 10a and 10b, or may be provided separately. When the first and second support units 13a and 13b are provided integrally, the material of both the first and second support units 13a and 13b is the same material as that of the first and second boards 10a and 10b. When the first and second support units 13a and 13b are provided separately, silicon oxides, polymers, and so forth may be examples of the material of the first and second support units 13a and 13b. Examples of polymers include polyimides, PMMA (PolyMethyl MethAcrylate), polystyrene, and so forth.

The slits 17a and 17b are sealed by sealing members 31a and 31b, respectively. The sealing members 31a and 31b may be integrated. In this case, the sealing member 31a and the sealing member 31b become one sealing member 31, and are provided in an annular shape along the outer surfaces of the first and second support units 13a and 13b, respectively. To give an example of the material of the sealing members 31a and 31b, an insulating resin may be used. A fluorine-based insulating resin may be an example of an insulating resin.

The first electrode unit 11 is provided inside the housing unit 10d. The first electrode unit 11 is provided on the first board 10a in the thermoelectric element 1. The second electrode unit 12 is provided inside the housing unit 10d. The second electrode unit 12 is provided on the second board 10b in the thermoelectric element 1. The first electrode unit 11 and the second electrode unit 12 form a pair of parallel flat plate-type electrodes. The thermoelectric element 1 is a parallel flat plate-type thermoelectric element.

In the thermoelectric element 1, the first electrode unit 11 includes, for example, platinum (work function: approximately 5.65 eV). The second electrode unit 12 includes, for example, tungsten (work function: approximately 4.55 eV). The electrode unit having the larger work function functions as an anode A (collector electrode), and the electrode unit having the smaller work function functions as a cathode K (emitter electrode). In the thermoelectric element 1, the first electrode unit 11 is the anode A, and the second electrode unit 12 is the cathode K. The thermoelectric element 1 like this makes use of the absolute temperature-induced electron emission phenomenon that is produced between the first electrode unit 11 and the second electrode unit 12 having different work functions. Consequently, the thermoelectric element 1 can convert thermal energy into electrical energy, even when the temperature difference between the first electrode unit 11 and the second electrode unit 12 is insignificant. Furthermore, the thermoelectric element 1 can convert thermal energy to electrical energy even when there is no temperature difference between the first electrode unit 11 and the second electrode unit 12. Note that the first electrode unit 11 may be used as the cathode K, and the second electrode unit 12 may be used as the anode A.

The thickness of both the first and second electrode units 11 and 12 along the first direction Z is, for example, 1 nm or more, up to 1 µm. More preferably, this thickness is 1 nm or more, up to 50 nm. The material of both the first and second electrode units 11 and 12 can be chosen from, for example, the following metals:
Platinum (Pt)
Tungsten (W)
Aluminum (Al)
Titanium (Ti)
Niobium (Nb)
Molybdenum (Mo)
Tantalum (Ta)
Rhenium (Re)

In the thermoelectric element 1, it suffices that a work function difference be created between the first electrode unit 11 and the second electrode unit 12. Consequently, it is possible to choose metals other than those listed above, for the material of the first electrode units 11 and 12. Furthermore, it is also possible to choose an alloy, an intermetallic compound, and a metal compound, apart from the metals listed above, for the material of the first and second electrode units 11 and 12. A metal compound is a combination of metal elements and non-metal elements. For example, lanthanum hexaboride (LaB₆) may be an example of a metal compound.

It is also possible to choose a non-metallic conductor for the material of the first and second electrode units 11 and 12. Examples of non-metallic conductors may include silicon (Si: for example, p-type Si or n-type Si), carbon-based materials such as graphene, and so forth.

If materials other than refractory metals is chosen for the material for the first electrode unit 11 and the second electrode unit 12, the advantages described below can be additionally provided. In the present specification, the refractory metals are, for example, W, Nb, Mo, Ta, and Re. When, for example, Pt is used for the first electrode unit (anode A) 11, it is preferable to use at least one of Al, Si, Ti, and LaB₆ for the second electrode unit (cathode K) 12.

For example, the melting points of Al and Ti are lower than those of the above refractory metals. Consequently, from both Al and Ti, better processability than the above refractory metals can be provided as an advantage.

For example, Si is easier to form than the above refractory metals. Consequently, from Si, more improved productivity of the thermoelectric element 1 can be provided as an additional advantage, besides the above-noted good processability.

For example, the melting point of LaB₆ is higher than those of Ti and Nb. However, the melting point of LaB₆ is lower than those of W, Mo, Ta, and Re. LaB₆ is easier to process than W, Mo, Ta, and Re. Moreover, the work function of LaB₆ is approximately 2.5 to 2.7 eV. LaB₆ is more likely to release electrons than the above-mentioned refractory metals. Consequently, LaB₆ can provide an additional advantage of further improving the electric power generation efficiency of the thermoelectric element 1.

Note that the structures of both the first electrode unit 11 and the second electrode unit 12 may have a single-layer structure comprised of the above materials, or have a laminated structure comprised of the above materials.

The first bonding wire 15a of the thermoelectric element 1 is electrically connected with the first electrode unit 11 inside the housing unit 10d. By this means, the first electrical contact 11a is provided between the first electrode unit 11 and the first bonding wire 15a, inside the housing unit 10d. On the board-joining surface 13aa of the first support unit 13a, the planar shape of the first bonding wire 15a is shaped like the letter "L", extending in both the second direction X and the third direction Y when viewed from the first direction Z. This is substantially the same as the planar shape of the first support unit 13a. The first bonding wire 15a is joined with the first joining metal 18a between the first support unit 13a and the second board 10b. The first joining metal 18a is provided on the second board 10b. The planar shape of the first joining metal 18a is shaped like the letter "L", extending in both the second direction X and the third direction Y when viewed from the first direction Z. This is substantially the same as the planar shape of the first bonding wire 15a on the board-joining surface 13aa.

The second bonding wire 16a of the thermoelectric element 1 is electrically connected with the second electrode unit 12 in the housing unit 10d. By this means, a second electrical contact 12a is provided between the second electrode unit 12 and the second bonding wire 16a, inside the housing unit 10d. On the board-joining surface 13ba of the second support unit 13b, the planar shape of the second bonding wire 16a is shaped like the letter "L", extending in both the second direction X and the third direction Y when viewed from the first direction Z. This is substantially the same as the planar shape of the second support unit 13b. The second bonding wire 16a is joined with the second joining metal 18b between the second support unit 13b and the first board 10a. The second joining metal 18a is provided on the first board 10a. The planar shape of the second joining metal 18b is shaped like the letter "L", extending in both the second direction X and the third direction Y when viewed from the first direction Z. This is substantially the same as the planar shape of the second bonding wire 16a on the board-joining surface 13ba.

The first and second joining metals 18a and 18b include, for example, metals that can be joined with the first and second bonding wires 15a and 16a. By this means, for example, as shown in FIG. 4, the second board 10b can be joined with the first board 10a by the joining of the first bonding wire 15a and the first joining metal 18a and the joining of the second bonding wire 16a and the second joining metal 18b. Then, the housing unit 10d is formed in the casing unit 10. When Au is used for the first and second bonding wires 15a and 16a and for the first and second joining metals 18a and 18b, the first and second bonding wires 15a and 16a can be joined with the first and second joining metals 18a and 18b, respectively, by way of thermocompression bonding and so forth. For the first and second bonding wires 15a and 16a, and for the first and second joining metals 18a and 18b, for example, metals that are capable of thermocompression, eutectic bonding and so forth, or alloys, can be used, besides gold.

Note that the work functions of the metals or alloys used for the first and second bonding wires 15a and 16a and the first and second joining metals 18a and 18b are preferably between the work function of the first electrode unit 11 and the work function of the second electrode unit 12, for example, from the perspective of preventing the decline of electric power generation efficiency. Furthermore, when an intermetallic compound is produced at the joint portion where metals are joined with each other by means of eutectic bonding and the like, the work function of the intermetallic compound produced is also preferably between the work function of the first electrode unit 11 and the work function of the second electrode unit 12.

The first bonding wire 15a is further provided on each of the inner surface of the first support unit 13a, the board-joining surface 13a, and the outer surface of the first support unit 13a. The first bonding wire 15a leads the first electrode unit 11 to the outside of the housing unit 10d. Furthermore, the second bonding wire 16a is provided on both the inner surface of the second support unit 13b and on the board-joining surface 13aa. The second bonding wire 16a leads the second electrode unit 12 to the outside of the housing unit 10d.

The first board 10a has a first main surface lOaf and a second main surface 10ab. The second main surface 10ab opposes the first main surface lOaf, and faces the upper surface of the semiconductor integrated circuit chip 230. The second main surface 10ab is bonded to the surface of the package 210, in the upper surface side of the semiconductor integrated circuit chip 230, by means of, for example, the adhesive member 30. Alternatively, the second main surface 10ab is fixed on surface of the package 210, in the upper surface side of the semiconductor integrated circuit chip 230, by means of, for example, a brazing material. The first outer casing terminal 101 and the second outer casing terminal 102 are both provided on the first main surface lOaf of the first board 10a. The first outer casing terminal 101 is electrically connected with the first bonding wire 15a. The second outer casing terminal 102 is electrically connected with the second bonding wire 16a. The first main surface lOaf has, for example, portions that project outward from the first and second support units 13a and 13b, respectively. The first outer casing terminal 101 is provided, for example, in the portion of the first main surface lOaf that projects outward from the first support unit 13a. The second outer casing terminal 102 is provided, for example, in the portion of the first main surface lOaf that projects outward from the second support unit 13b. In the thermoelectric element 1, the first outer casing terminal 101 uses the pattern of the first bonding wire 15a, and is formed of the same conductor as that of the first bonding wire 15a. Furthermore, the second outer casing terminal 102 uses the pattern of the second joining metal 18b, and is formed of the same conductor as that of the second joining metal 18b.

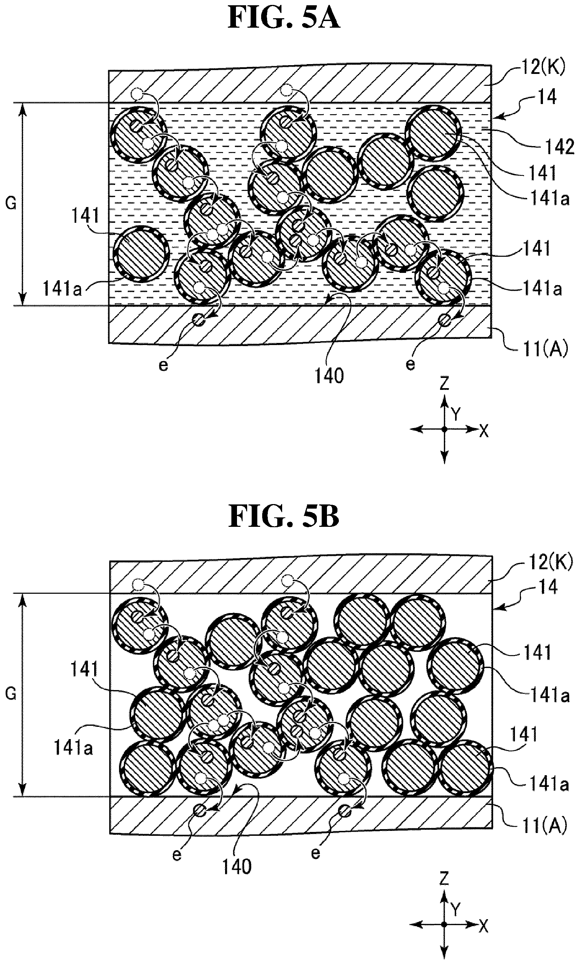

FIG. 5A is a schematic cross-sectional view to show an example of a middle unit 14. FIG. 5B is a schematic cross-sectional view to show another example of the middle unit 14.

As shown in FIG. 5A, the middle unit 14 is provided between the first electrode unit 11 and the second electrode unit 12, inside the housing unit 10d. The middle unit 14 includes nanoparticles having a work function between the work function of the first electrode unit 11 and the work function of the second electrode unit 12. The middle unit 14 is, for example, a portion where the electrons released from the second electrode unit (cathode K) 12 travel toward the first electrode unit (anode A) 11.

An inter-electrode gap G is provided between the first electrode unit 11 and the second electrode unit 12, along the first direction Z. In the thermoelectric element 1, the inter-electrode gap G is provided in accordance with the thickness of each of the first and second support units 13a and 13b along the first direction Z. An example of the width of the inter-electrode gap G is, for example, a finite value of 10 µm or less. The narrower the width of the inter-electrode gap G, the more efficiently the electrons e can be released from the second electrode unit (cathode K) 12, and the more efficiently the electrons e can travel from the second electrode unit 12 to the first electrode unit (anode A) 11. Consequently, the electric power generation efficiency of the thermoelectric element 1 is improved. Furthermore, the narrower the width of the inter-electrode gap G, the thinner the thickness of the thermoelectric element 1 along the first direction Z can be. Consequently, for example, the width of the inter-electrode gap G should be narrow. More preferably, the width of the inter-electrode gap G is, for example, 10 nm or more, up to 100 nm. Note that the width of the inter-electrode gap G and the thickness of the first and second support unit 13a and 13b along the first direction Z are substantially equivalent.

The middle unit 14 includes, for example, a plurality of nanoparticles 141 and a solvent 142. The nanoparticles 141 are dispersed in the solvent 142. The middle unit 14 is formed, for example, by filling the gap unit 140 with the solvent 142, in which the nanoparticles 141 are dispersed. The particle size of the nanoparticles 141 is smaller than the inter-electrode gap G The particle size of the nanoparticles 141 is, for example, a finite value of 1/10 of the inter-electrode gap G, or less. When the particle size of the nanoparticles 141 is set to 1/10 or less of the inter-electrode gap G, it becomes easy to form the middle unit 14 including the nanoparticles 141, in the gap unit 140. By this means, workability is improved in the production of the thermoelectric element 1.

The nanoparticles 141 include a conductor, for example. The value of the work function of the nanoparticles 141 is, for example, between the value of the work function of the first electrode unit 11 and the value of the work function of the second electrode unit 12. For example, the value of the work function of the nanoparticles 141 is in the range of 3.0 eV to 5.5 eV. By this means, the electrons e released in the middle unit 14 can travel from the second electrode unit 12 to the first electrode unit 11 via the nanoparticles 141, for example. This makes it possible to further increase the amount of electrical energy to generate, compared to the case where no nanoparticles 141 are present in the middle unit 14.

At least one of gold and silver can be chosen as an example of the material of the nanoparticles 141. Note that it suffices that the value of the work function of the nanoparticles 141 be between the value of the work function of the first electrode unit 11 and the value of the work function of the second electrode unit 12. Consequently, it is also possible to choose a conductive material other than gold and silver, for the material of the nanoparticles 141.

The particle size of the nanoparticles 141 is, for example, a finite value of 1/10 or less of the inter-electrode gap G To be more specific, the particle size of the nanoparticles 141 is 2 nm or more, up to 10 nm. Furthermore, the nanoparticles 141 may have, for example, an average particle size (for example, D50) of 3 nm or more, up to 8 nm. The average particle size can be measured using, for example, a particle size distribution measuring instrument. AS for the particle size distribution measuring instrument, for example, a particle size distribution measuring instrument to use the laser diffraction/scattering method (for example, Nanotrac Wave II-EX150 manufactured by Microtrac BEL) may be used.

The nanoparticles 141 have, for example, an insulating film 141a on their surface. At least one of an insulating metal compound and an insulating organic compound can be chosen as an example of the material of the insulating film 141a. As for examples of insulating metal compounds, silicon oxides and alumina may be given, for example. Alkanethiol (for example, dodecanethiol) and the like are examples of insulating organic compounds. The thickness of the insulating film 141a is, for example, a finite value of 20 nm or less. When an insulating film 141a like this is provided on the surface of the nanoparticles 141, the electrons e can, for example, travel between the second electrode unit (cathode K) 12 and the nanoparticles 141, and between the nanoparticles 141 and the first electrode unit (anode A) 11, by making use of the tunnel effect. Consequently, for example, the electric power generation efficiency of the thermoelectric element 1 is expected to improve.

As for the solvent 142, for example, a liquid having a boiling point of 60°C or higher can be used. Consequently, it is possible to reduce the vaporization of the solvent 142, even when the thermoelectric element 1 is used, in an environment of room temperature (for example, 15°C to 35°C) or higher. By this means, the deterioration of the thermoelectric element 1 due to the vaporization of the solvent 142 can be reduced. At least one of an organic solvent and water can be chosen as an example of the liquid. Examples of the organic solvent include methanol, ethanol, toluene, xylene, tetradecane, alkanethiol, and so forth. Note that the solvent 142 is preferably a liquid that has a high electrical resistance value and is insulating.

Furthermore, as shown in FIG. 5B, the middle unit 14 may include only the nanoparticles 141, and not include the solvent 142. If the middle unit 14 includes only the nanoparticles 141, it is not necessary to take into account the vaporization of the solvent 142 even when, for example, the thermoelectric element 1 is used in a high temperature environment. This makes it possible to reduce the deterioration of the thermoelectric element 1 in a high temperature environment.

### < Operation of thermoelectric element 1 >

When the thermoelectric element 1 is given thermal energy, for example, electrons e are released from the second electrode unit (cathode K) 12 toward the middle unit 14. The released electrons e travel from the middle unit 14 to the first electrode unit (anode A) 11. The current flows from the first electrode unit 11 to the second electrode unit 12. In this way, thermal energy is converted into electrical energy.

With this semiconductor integrated circuit device 200, the thermoelectric element 1 includes, in the housing unit 10d of the casing unit 10, the first electrode unit 11, the second electrode unit 12, having a work function different from that of the first electrode unit 11, and a middle unit 14, including nanoparticles 141 that have a work function between the work function of the first electrode unit 11 and the work function of the second electrode unit 12. By this means, the thermoelectric element 1 can generate electric power without creating temperature differences inside the thermoelectric element 1. Consequently, the thermoelectric element 1 does not require low-temperature materials or a chiller for cooling low-temperature materials, like a Seebeck element. As a result of making low-temperature materials or a chiller for cooling low-temperature materials unnecessary, it is possible to prevent the manufacturing cost of the semiconductor integrated circuit device 200 from increasing, and prevent the size of the semiconductor integrated circuit device 200 from becoming bigger.

Furthermore, according to the semiconductor integrated circuit device 200, the following additional advantages can be provided:
(1) The casing unit 10 of the thermoelectric element 1 is provided on the upper surface of the semiconductor integrated circuit chip 230. By this means, it is not necessary to secure a new area for mounting the thermoelectric element 1 in the circuit board 260, so that it is possible to prevent the circuit board 260 from increasing in size.
(2) Since it is possible to prevent the circuit board 260 from increasing in size, it is also possible to prevent the size of secondary products using the semiconductor integrated circuit device 200 such as, for example, circuit boards for electronic devices, from increasing.
(3) The first and second electrical contacts 11a and 12a are both provided inside the housing unit 10d. By this means, when incorporating the semiconductor integrated circuit device 200 in secondary products, for example, while handling the semiconductor integrated circuit device 200, or while working on the installation of the semiconductor integrated circuit device 200, it is possible to prevent the first and second electrical contacts 11a and 12a from breaking or getting damaged. By this means, it is possible to prevent the loss of the semiconductor integrated circuit device 200, which might occur during the manufacturing of secondary products.
(4) The casing unit 10 includes a first main surface lOaf, and a second main surface 10ab, opposing the first main surface lOaf and facing the upper surface of the semiconductor integrated circuit chip 230. Then, the first and second outer casing terminals 101 and 102 are both provided on the first main surface lOaf of the first board 10a. The first main surface lOaf can, for example, provide a large area for each of the first and second outer casing terminals 101 and 102, compared to the side surfaces of the casing unit 10. Furthermore, compared to the side surfaces of the casing unit 10, the first main surface lOaf is easy for the operator to see/identify, and makes it easy for the work robot to find out the work point. Based on these, for example, it is possible to facilitate the work for establishing electrical connections between the thermoelectric element 1 and secondary products, and, for example, improve the throughput of secondary products. In addition, the reliability of the assembling of secondary products having the semiconductor integrated circuit device 200 also improves.

### (First embodiment: first modification)

Next, a first modification of the first embodiment will be described below. The first modification relates to a modification of the thermoelectric element.

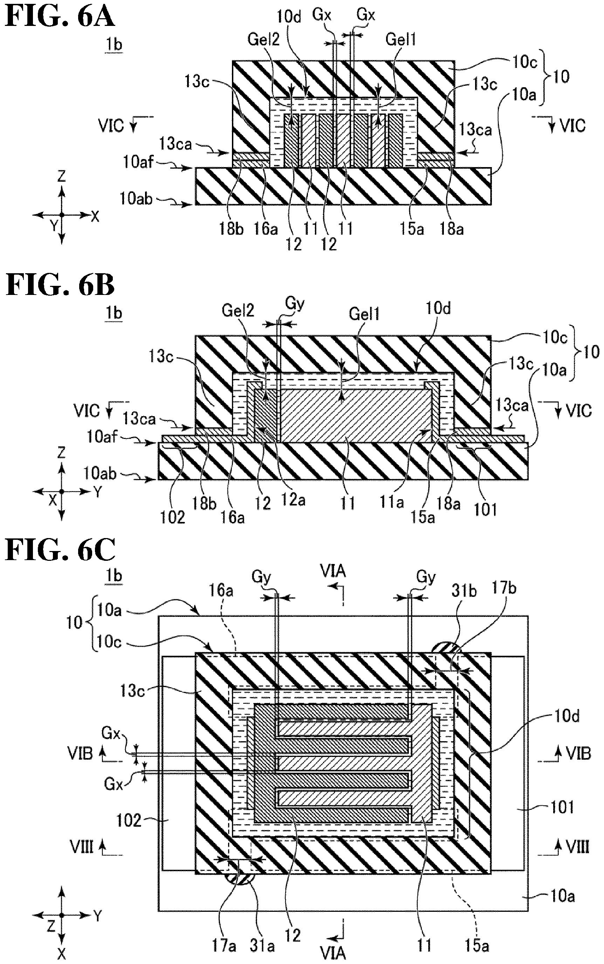

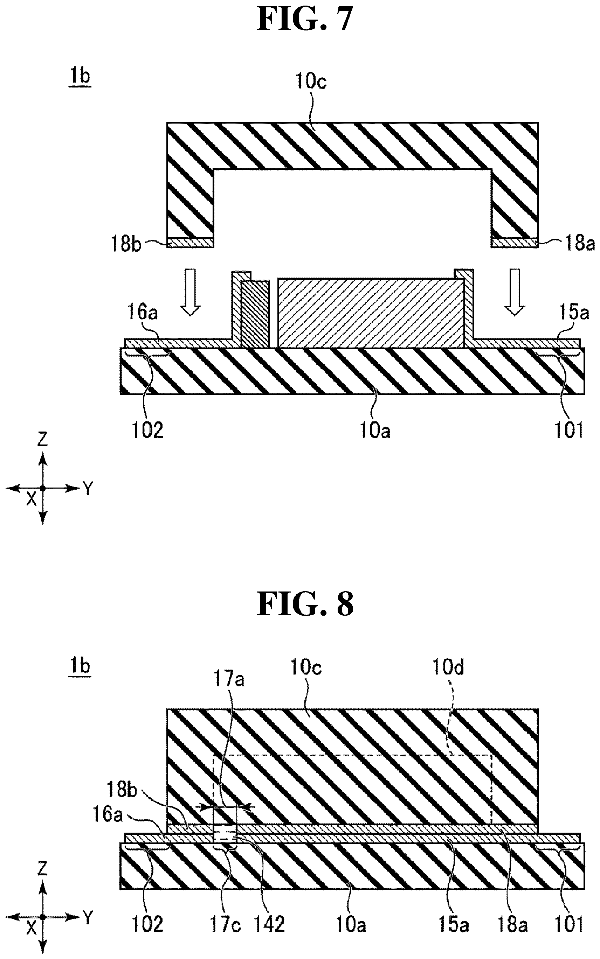

FIGs. 6A to 6C are schematic cross-sectional views to show an example of a thermoelectric element 1 according to the first modification. The schematic cross section shown in FIG. 6A is taken along the line VIA-VIA in FIG. 6C. The schematic cross section shown in FIG. 6B is taken along the line VIB-VIB in FIG. 6C. The schematic cross section shown in FIG. 6C is taken along the line VIC-VIC in FIGs. 6A and 6B. FIG. 7 is a schematic cross-sectional view to show an example of joining. FIG. 7 corresponds to the schematic cross section shown in FIG. 6B.

As shown in FIGs. 6A to 6C, a thermoelectric element 1b according to the first modification is provided, which is different from the thermoelectric element 1 in that
the planar shape of the first electrode unit 11 seen from the first direction Z and the planar shape of the second electrode unit 12 seen from the first direction Z are both comb-toothed.

The comb teeth of the first and second electrode units 11 and 12 both extend along the third direction Y. The angle of comb teeth is opposite between the first electrode unit 11 and the second electrode unit 12. The comb-tooth unit of the first electrode unit 11 and the comb-tooth unit of the second electrode unit 12 mesh with each other while kept separated from each other. By this means, an inter-electrode gap G is defined between the comb-tooth unit of the first electrode unit 11 and the comb-tooth unit of the second electrode unit 12. In the thermoelectric element 1b, the direction in which the inter-electrode gap G is defined is two directions, namely the second direction X (inter-electrode gap Gx) and the third direction Y (inter-electrode gap Gy) (see FIG. 6C).

For the thermoelectric element, a thermoelectric element 1b having comb tooth-type electrodes can also be used, in addition to the thermoelectric element 1 having parallel flat plate-type electrodes.

The first and second electrode units 11 and 12 are comb tooth-type in the thermoelectric element 1b, so that the fluctuation of the inter-electrode gap G due to the heat of the semiconductor integrated circuit chip 230 is reduced, compared to the parallel flat plate-type thermoelectric element 1. By this means, for example, the thermoelectric element 1b can provide an additional advantage of making it easy to reduce the small fluctuations in the efficiency of electric power generation, compared to the thermoelectric element 1.

Furthermore, the thermoelectric element 1b has been further devised as follows:
- The casing unit 10 includes a first board 10a and a lid body 10c; and
- The first electrode unit 11, the second electrode unit 12, the first bonding wire 15a and the second bonding wire 16a are all provided on the first main surface lOaf.

Hereinafter, the thermoelectric element 1b will be described in more detail.

The lid body 10c includes the third support unit 13c. The third support unit 13c extends from the lid body 10c toward the first board 10a, along the first direction Z. The planar shape of the third support unit 13a is shaped like a frame when viewed from the first direction Z. The lid body 10c may be provided integrally with the third support unit 13c, or may be provided separately.

The first and second electrode units 11 and 12 are both provided inside the housing unit 10d. Planes that expand in the second direction X and the third direction Y are surrounded by the lid body 10c, and surrounded by the third support unit 13c, along both the second direction X and the third direction Y, thereby forming the housing unit 10d in the casing unit 10.

The first bonding wire 15a is electrically connected with the first electrode unit 11 inside the housing unit 10d. By this means, the first electrical contact 11a is provided between the first electrode unit 11 and the first bonding wire 15a, inside the housing unit 10d. The second bonding wire 16a is electrically connected with the second electrode unit 12 in the housing unit 10d. By this means, a second electrical contact 12a is provided between the second electrode unit 12 and the second bonding wire 16a, inside the housing unit 10d.

On the board-joining surface 13ca of the third support unit 13c, the planar shape of the first bonding wire 15a is shaped like the letter "L", extending in both the second direction X and the third direction Y when viewed from the first direction Z. The first bonding wire 15a is joined with the first joining metal 18a between the third support unit 13c and the first board 10a. The first joining metal 18a is provided on the board-joining surface 13ca of the lid body 10c. The planar shape of the first joining metal 18a is shaped like the letter "L", extending in both the second direction X and the third direction Y when viewed from the first direction Z. This is substantially the same as the planar shape of the first bonding wire 15a on the board-joining surface 13ca.

On the board-joining surface 13ca of the third support unit 13c, the planar shape of the second bonding wire 16a is shaped like the letter "L", extending in both the second direction X and the third direction Y when viewed from the first direction Z. The second bonding wire 16a is joined with the second joining metal 18b between the third support unit 13c and the first board 10a. The second joining metal 18b is provided on the board-joining surface 13ca of the lid body 10c. The planar shape of the second joining metal 18b is shaped like the letter "L", extending in both the second direction X and the third direction Y when viewed from the first direction Z. This is substantially the same as the planar shape of the second bonding wire 16a on the board-joining surface 13ca.

By this means, for example, as shown in FIG. 7, the lid body 10c can be joined with the first board 10a by means of the joining of the first bonding wire 15a and the first joining metal 18a and the joining of the second bonding wire 16a and the second joining metal 18b. Then, the housing unit 10d is formed in the casing unit 10.

The first bonding wire 15a and the second bonding wire 16a are separated from each other on the first main surface lOaf, via slits 17a and 17b, so as not to contact each other. The first and second joining metals 18a and 18b may be electrically connected with the first and second bonding wires 15a and 16a, respectively. In this case, as shown in FIG. 6C, it suffices that the first joining metal 18a and the second joining metal 18b be separated from each other, via the slits 17a and 17b, so as not to contact each other. By this means, it is possible to prevent the short circuiting of the first bonding wire 15a and the second bonding wire 16a via the first and second joining metals 18a and 18b.

FIG. 8 is a schematic cross-sectional view to show an example of a slit. The schematic cross section shown in FIG. 8 is taken along the line VIII-VIII in FIG. 6C. As shown in FIG. 8, the slits 17a and 17b create a small gap 17c in the thermoelectric element 1b. It then follows that the solvent 142 injected in the gap unit 140 might leak from this small gap. Consequently, as shown in FIG. 6C, sealing members 31a and 31b may be provided between the first board 10a and the lid body 10c, and
the slits 17a and 17b may be closed with the sealing members 31a and 31b, respectively. By this means, it is possible to prevent the solvent 142 from leaking through the slits 17a and 17b.

In the thermoelectric element 1b, furthermore, a gap Gel 1 is provided between the first electrode unit 11 and the lid body 10c along the first direction Z, and a gap Gel 2 is provided between the second electrode unit 12 and the lid body 10c. By providing the gaps Gel 1 and Gel 2, it is possible to house both the first and second electrode units 11 and 12 in the housing unit 10d, without creating a gap between the lid body 10c and the first board 10a. The length of the gap Gel 1 and the length of the gap Gel 2 may be provided so as to be equal to each other, or may be provided so as to be different from each other. The latter case may take place when, for example, the surface of either one electrode unit is subjected to surface treatment such as coating, surface modification or the like, in order to make the difference between the work function of the first electrode unit 11 and the work function of the second electrode unit 12 bigger. Alternatively, the latter case may take place when the first electrode unit 11 and the second electrode unit 12, made of different materials, are formed simultaneously in one etching step. Furthermore, by providing the gaps Gel 1 and Gel 2, the upper surface of the first electrode unit 11 and the upper surface of the second electrode unit 12 contact the middle unit 14. Consequently, it is possible to allow the electrons e to travel through the upper parts of the electrodes 11 and 12 (especially, their upper surfaces, the corner portions of the upper surfaces, etc.), in addition to the opposing surfaces of the electrode units 11 and 12. By this means, it is possible to increase the amount of electric energy to produce.

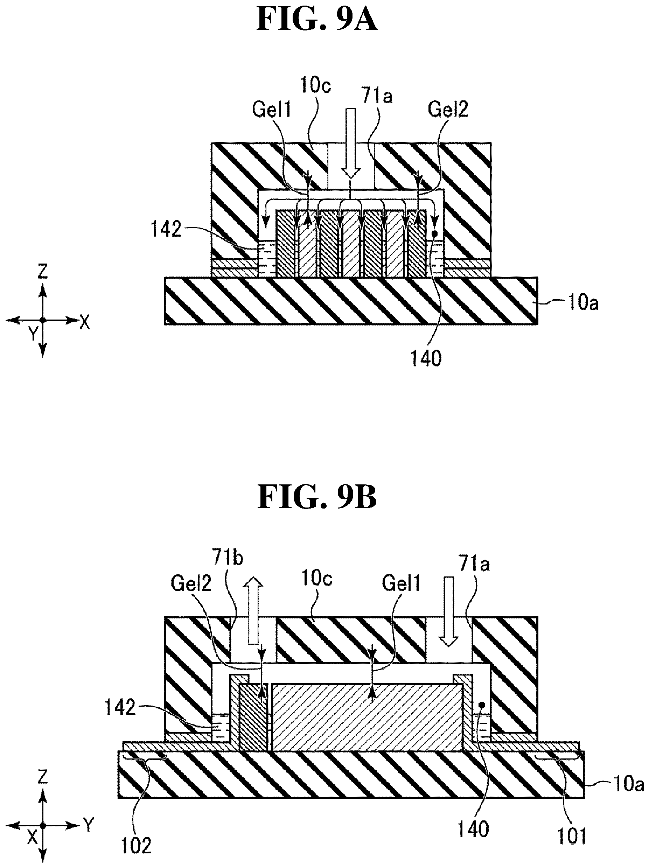

FIGs. 9A and 9B are schematic cross-sectional views to show an example of solvent injection. The schematic cross section shown in FIG. 9A corresponds to the schematic cross section shown in FIG. 6A. The schematic cross section shown in FIG. 9B corresponds to the schematic cross section shown in FIG. 6B.

As shown in FIGs. 9A and 9B, a first filling hole 71a and a second filling hole 71b may be provided in the lid body 10c. The first and second filling holes 71a and 71b are used, for example, to inject the solvent 142 into the gap unit 140. When the first and second filling holes 71a and 71b are used to inject the solvent 142, if the gaps Gel 1 and Gel 2 were in the gap unit 140, the solvent 142 would pass through the gaps Gel 1 and Gel 2, and come between the first electrode unit 11 and the second electrode unit 12. By this means, it is possible to provide an advantage that it is possible to easily fill between the first electrode unit 11 and the second electrode unit 12 with the solvent 142.

The solvent 142 is injected in the gap unit 140 from, for example, the first filling hole 71a. In this case, the other second filling hole 71b is used as, for example, an air-vent hole. Furthermore, the solvent 142 may be injected through the first filling hole 71a, while creating a vacuum inside the gap unit 140, through the second filling hole 71b.

As with the first modification, a thermoelectric element 1b having comb tooth-type electrodes can also be used for the thermoelectric element, besides the thermoelectric element 1 having parallel flat plate-type electrodes.

### (Second embodiment)

A second embodiment relates to an example of a power supply circuit 300 that can be used in the semiconductor integrated circuit device 200 according to the first embodiment.

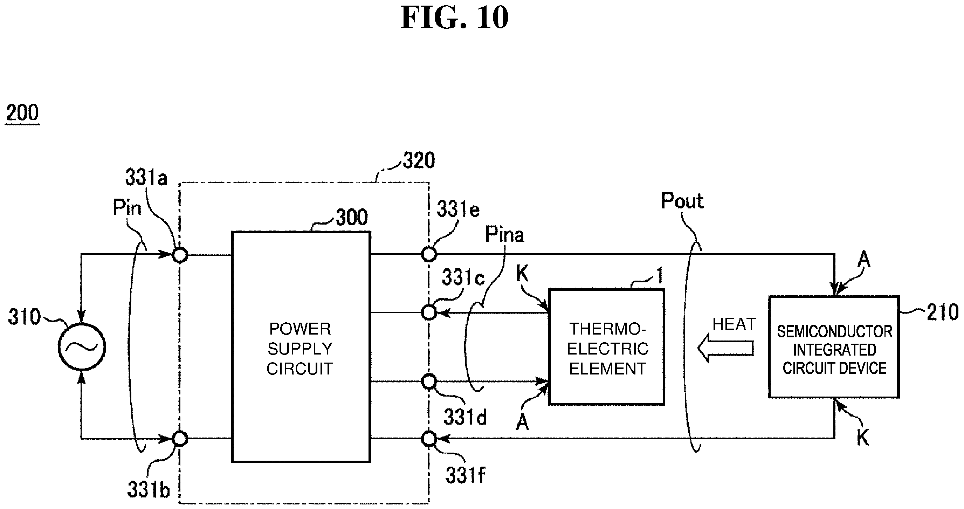

FIG. 10 is a schematic block diagram to show an example of a semiconductor integrated circuit device 200 with an electric power generation function according to the second embodiment.

As shown in FIG. 10, the power supply circuit 300 is provided on, for example, a circuit board 320 (the circuit board 320 may be the same one as the above-described circuit board 260). For example, the first outer terminal 331a to the sixth outer terminal 331f are provided on the circuit board 320. The first outer terminal 331a and the second outer terminal 331b are electrically connected with an external power supply, which is, for example, a commercial power supply 310. By this means, external input power Pin is input to the power supply circuit 300 via the first and second outer terminals 331a and 331b. The third outer terminal 331c and the fourth outer terminal 331d are electrically connected with the thermoelectric element 1. By this means, auxiliary input power Pina is input to the power supply circuit 300 via the third and fourth outer terminals 331c and 331d. The third outer terminal 331c is electrically connected with the cathode K of the thermoelectric element 1. The fourth outer terminal 331d is electrically connected with the anode A of the thermoelectric element 1. The fifth outer terminal 331e and the sixth outer terminal 331f are electrically connected with the package 210. By this means, the power supply circuit 300 outputs LSI input power Pout (semiconductor integrated circuit device input power) via the fifth and sixth outer terminals 331e and 331f.

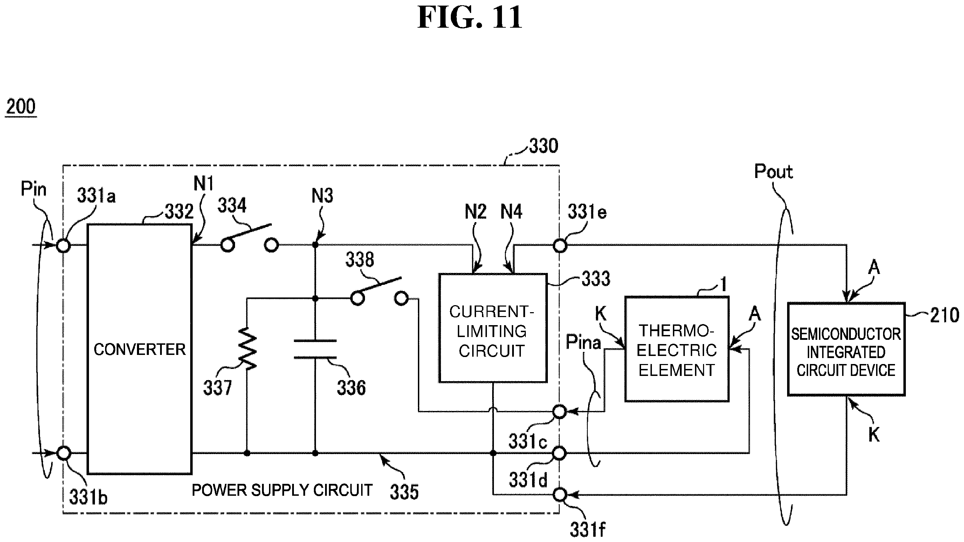

FIG. 11 is a schematic circuit diagram to show an example of the semiconductor integrated circuit device 200 according to the second embodiment.

As shown in FIG. 11, the power supply circuit 300 includes a converter 332. When the external power supply is the commercial power supply 310, the converter 332 becomes an AC-DC converter (rectifier circuit). When the external power supply is a battery, the converter 332 becomes a DC-DC converter. When the converter 332 is an AC-DC converter, alternating-current power is rectified to direct-current power. The rectified direct-current power is supplied to a current-limiting circuit 333. The current-limiting circuit 333 limits the direct current to generate and output LSI input power Pout.

The higher potential-side output node N1 of the converter 332 is electrically coupled with the higher potential-side input node N2 of the current-limiting circuit 333 via the first switch 334. The connection node N3 between the first switch 334 and the higher potential-side input node N2 is electrically coupled with the lower potential-side wire 335 of the power supply circuit 300 via the capacitor 336. The capacitor 336 is a smoothing capacitor. Furthermore, a resistor 337 is connected to the capacitor 336 in parallel. The resistor 337 is a discharge resistor. The connection node N3 is electrically coupled with the cathode K of the thermoelectric element 1 via the second switch 338. For the first and second switches 334 and 338, for example, transistors are used. The higher potential-side output node N4 of the current-limiting circuit 333 is electrically coupled with a higher-potential side power supply terminal (hereinafter referred to as "A" for ease of explanation) of the package 210. The lower-potential side (hereinafter referred to as "K" for ease of explanation) of the package 210 and the anode A of the thermoelectric element 1 are electrically coupled with the lower potential-side wire 335.

When operating the semiconductor integrated circuit chip 230 of the package 210, the first switch 334 is turned on, and the second switch 338 is turned off. The higher potential-side output node N1 is electrically connected with one electrode of the capacitor 336, and the capacitor 336 is charged. After the capacitor 336 is charged full, the higher potential-side output node N1 is electrically connected with the higher potential-side input node N2. The converter 332 supplies current to the current-limiting circuit 333. The current-limiting circuit 333 limits the supplied current to generate and output LSI input power Pout. By this means, the semiconductor integrated circuit chip 230 in the package 210 operates.

When the semiconductor integrated circuit chip 230 operates, the semiconductor integrated circuit chip 230 produces heat. The heat is transferred to the thermoelectric element 1. Eventually, the thermoelectric element 1 assumes a state in which the thermoelectric element 1 can generate electric power -- for example, a state in which the thermoelectric element 1 can generate a current that can charge the capacitor 336. After the thermoelectric element 1 is ready to generate electric power, the second switch 338 is turned on. The cathode K of the thermoelectric element 1 is electrically connected with one electrode of the capacitor 336. The thermoelectric element 1 supplies a current to the current-limiting circuit 333, together with the converter 332. By this means, the semiconductor integrated circuit chip 230 keeps operating.

Furthermore, using the first switch 334 and the second switch 338, it is possible to choose to couple either the higher potential-side output node N1 or the cathode K of the thermoelectric element 1 to one electrode of the capacitor 336.

For example, when operating the semiconductor integrated circuit chip 230, the first switch 334 is turned on and the second switch 338 is turned off, to operate the semiconductor integrated circuit chip 230 using the external input power Pin. The state in which the semiconductor integrated circuit chip 230 is operated using the external input power Pin is referred to as "normal energy mode", for ease of explanation.

After the semiconductor integrated circuit chip 230 operates, for example, once the thermoelectric element 1 assumes a state in which the thermoelectric element 1 can generate a current that can charge the capacitor 336, the first switch 334 is turned off, and the second switch 338 is turned off. The power supply source switches from the external input power Pin to the auxiliary input power Pina. By this means, the operation mode of the semiconductor integrated circuit chip 230 switches from normal energy mode to energy saving mode, in which the auxiliary input power Pina from the thermoelectric element 1 is used. Normal energy mode can switch to energy saving mode automatically or manually. Energy saving mode generally means reducing the power consumption of a commercial power supply or a battery. However, the energy saving mode according to the second embodiment means switching to auxiliary input power Pina, which is different from normal energy mode.

Furthermore, as for the capacitor 336, a smoothing capacitor provided in the power supply circuit 300 can also be used. When a smoothing capacitor is used, the thermoelectric element 1 can be connected with the power supply circuit 300 by using existing circuit elements in the power supply circuit 300. By this means, it is possible to prevent the number of circuit elements and electronic components 330 required in the power supply circuit 300 from increasing.

### (Second embodiment: first modification)

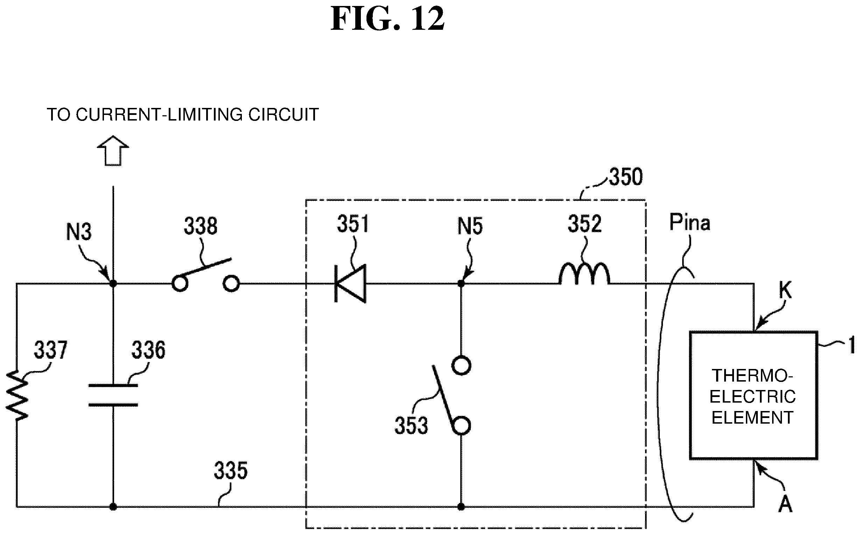

FIG. 12 is a schematic circuit diagram to show an example of a semiconductor integrated circuit device 200 with a power generation function according to the first modification of the second embodiment.

Cases might occur where the electric power generated by the thermoelectric element 1 cannot secure a sufficient voltage for the semiconductor integrated circuit chip 230 to operate. In this case, the thermoelectric element 1 may be connected with the power supply circuit 300 via a booster circuit 350. FIG. 12 shows a schematic circuit showing an example of the booster circuit 350.

As shown in FIG. 12, the booster circuit 350 includes, for example, a diode 351, a coil 352, and a third switch 353. The cathode of the diode 351 is electrically coupled with one electrode of the capacitor 336 via the second switch 338. The anode of the diode 351 is electrically coupled with the cathode K of the thermoelectric element 1 via a coil 352. The coil 352 is a choke coil. The connection node N5 between the anode of the diode 351 and the coil 352 is electrically coupled with the lower potential-side wire 335 via a third switch 353. For the third switch 353, for example, a transistor is used.

The operation of the booster circuit 350 boosts the voltage of the auxiliary input power Pina in the following manner. First, the second switch 338 is turned on to electrically couple the cathode K of the thermoelectric element 1 with one electrode of the capacitor 336. In this state, the third switch 353 is turned on. A current flow from the cathode K of the thermoelectric element 1 to the lower potential-side wire 335, via the coil 352. Then, the third switch 353 is turned off. The current from the coil 352 does not become zero immediately. Consequently, the current from the coil 352 flows to the connection node N3 at once, via the diode 351 and the second switch 338. The diode 351 prevents the backflow of current from the connection node N3. By repeating turning on and off the third switch 353 in this way, the voltage of the auxiliary input power Pina is boosted.

In this way, the thermoelectric element 1 may be connected with the power supply circuit 300 via the booster circuit 350. Note that the booster circuit is not limited to the booster circuit 350 shown in FIG. 12. A well-known booster circuit such as a transformer can be used for the booster circuit. Furthermore, the booster circuit can be provided in the power supply circuit 300.

Although some of the embodiments of the present invention have been described above, these embodiments are presented simply as examples, and are by no means intended to limit the scope of the present invention. For example, these embodiments can be implemented in appropriate combinations. Furthermore, the present invention can be implemented in various novel forms apart from the several embodiments described above. Consequently, each of the several embodiments described above can be omitted, replaced, or changed in a variety of ways without departing from the gist of the present invention. Such novel forms and modifications are included in the scope and gist of the present invention, as well as in the scope of the invention recited in the claims and any equivalent of the invention recited in the claims.

### REFERENCE SIGNS LIST

- 1, 1b:: thermoelectric element
- 10:: casing unit
- 10a:: first board
- lOaf:: first main surface
- 10ab:: second main surface
- 10b:: second board
- 10c:: lid body
- 10d:: housing unit
- 11:: first electrode unit
- 11a:: first electrical contact
- 12:: second electrode unit
- 12a:: second electrical contact
- 13a:: first support unit
- 13aa:: board joining surface
- 13b:: second support unit
- 13ba:: board joining surface
- 13c:: third support unit
- 13ca:: board joining surface
- 14:: middle unit
- 15a:: first bonding wire
- 16a:: second bonding wire
- 17a:: slit
- 17b:: slit
- 18a:: first joining metal
- 18b:: second joining metal
- 30:: adhesive member
- 31:: sealing member
- 71a:: first filling hole
- 71b:: second filling hole
- 101:: first outer casing terminal
- 102:: second outer casing terminal
- 140:: gap unit
- 141:: nanoparticles
- 141a:: insulating film
- 142:: solvent
- 200:: semiconductor integrated circuit device with electric power generation function
- 210:: package
- 220:: outer terminal
- 221a:: first bonding wire
- 221b:: second bonding wire
- 230:: semiconductor integrated circuit chip
- 260:: circuit board
- 270:: electrical wire
- 300:: power supply circuit
- 310:: commercial power supply
- 320:: circuit board
- 330:: electronic component
- 331a:: first outer terminal
- 331b:: second outer terminal
- 331c:: third outer terminal
- 331d:: fourth outer terminal
- 331e:: fifth outer terminal
- 331f:: sixth outer terminal
- 332:: converter
- 333:: current limiting circuit
- 334:: first switch
- 335:: lower potential-side wire
- 336:: capacitor
- 337:: resistor
- 338:: second switch
- 350:: booster circuit
- 351:: diode
- 352:: coil
- 353:: third switch
- G:: inter-electrode gap
- Gel 1:: gap
- Gel 2:: gap
- Gx:: inter-electrode gap
- Gy:: inter-electrode gap
- Pin:: external input power
- Pina:: auxiliary input power
- Pout:: LSI input power
- Z:: first direction
- X:: second direction
- Y:: third direction

## Claims

1. A semiconductor integrated circuit device with an electric power generation function, comprising a semiconductor integrated circuit device and a thermoelectric element to convert thermal energy released from the semiconductor integrated circuit device into electrical energy,
wherein the semiconductor integrated circuit device includes a package to house a semiconductor integrated circuit chip,
wherein the semiconductor integrated circuit chip has a lower surface opposing a circuit board and an upper surface opposing the lower surface,
wherein the thermoelectric element includes
a casing unit having a housing unit,
a first electrode unit provided inside the housing unit,
a second electrode unit provided inside the housing unit, separated from and opposing the first electrode unit in a first direction, and having a work function different from that of the first electrode unit, and
a middle unit provided between the first electrode unit and the second electrode unit, and including a nanoparticle having a work function between the work function of the first electrode unit and the work function of the second electrode unit, in the housing unit, and
wherein the casing unit is provided on an upper surface side of the semiconductor integrated circuit chip.

2. The semiconductor integrated circuit device with the electric power generation function according to claim 1,
wherein the thermoelectric element further includes
a first bonding wire, electrically connected with the first electrode unit, and leading the first electrode unit to outside of the housing unit, and
a second bonding wire, electrically connected with the second electrode unit, and leading the second electrode unit to outside of the housing unit, and
wherein a first electrical contact between the first electrode unit and the first bonding wire and a second electrical contact between the second electrode unit and the second bonding wire are both provided inside the housing unit.

3. The semiconductor integrated circuit device with the electric power generation function according to claim 2,
wherein the casing unit includes a first board having a first main surface and a second main surface opposing the first main surface and facing the upper surface of the semiconductor integrated circuit chip,
wherein the thermoelectric element further includes
a first outer terminal, electrically connected with the first bonding wire, and
a second outer terminal, electrically connected with the second bonding wire, and
wherein the first outer terminal and the second outer terminal are both provided on the first main surface of the first board.

4. The semiconductor integrated circuit device with the electric power generation function according to any one of claims 1 to 3,
wherein the thermoelectric element includes at least one of a parallel flat plate-type thermoelectric element and a comb tooth-type thermoelectric element.

5. The semiconductor integrated circuit device with the electric power generation function according to any one of claims 1 to 4, further comprising a power supply circuit, capable of receiving as input each of external input power supplied from outside and auxiliary input power supplied from the thermoelectric element, converting each of the external input power and the auxiliary input power into semiconductor integrated circuit device input power, and outputting the semiconductor integrated circuit device input power to the semiconductor integrated circuit device.
